**Europäisches Patentamt**

**European Patent Office**

**Office européen des brevets**

(19)

(11) Veröffentlichungsnummer: **0 186 806**

**B1**

(12) **EUROPÄISCHE PATENTSCHRIFT**

(45) Veröffentlichungstag der Patentschrift:
10.05.89

(51) Int. Cl.⁴: **H 04 B 3/14, H 03 H 7/19**

(21) Anmeldenummer: **85115484.9**

(22) Anmeldetag: **05.12.85**

(54) **Einstellbarer, mindestens einen Laufzeit-Fixpunkt aufweisender, verlustbehafteter Laufzeitentzerrer.**

(30) Priorität: **06.12.84 DE 3444560**

(43) Veröffentlichungstag der Anmeldung:
**09.07.86 Patentblatt 86/28**

(45) Bekanntmachung des Hinweises auf die Patenterteilung:
**10.05.89 Patentblatt 89/19**

(84) Benannte Vertragsstaaten:
**AT CH DE FR IT LI NL SE**

(56) Entgegenhaltungen:
**US-A-2 304 545**
**US-A-2 682 037**
**US-A-3 518 581**

**PATENTS ABSTRACTS OF JAPAN, Band 3, Nr. 141
(E-153), 21. November 1979, Seite 102 E 153; & JP - A
- 53 25 816 (NIPPON DENKI)**
**PATENTS ABSTRACTS OF JAPAN, Band 6, Nr. 147
(E-123), 1025 , 6. August 1982; & JP - A - 55 145 445
(FUJITSU)**

(73) Patentinhaber: **Siemens Aktiengesellschaft Berlin
und München, Wittelsbacherplatz 2, D-8000
München 2 (DE)**

(72) Erfinder: **Pfitzenmaier, Gerhard, Dr.,
Hörkherstrasse 28, D-8000 München 21 (DE)**

EP 0 186 806 B1

## Beschreibung

Die Erfindung betrifft einen einstellbaren Laufzeitentzerrer gemäß dem Oberbegriff des Patentanspruches 1.

Zur Optimierung von Nachrichtenübertragungssystemen werden Laufzeitentzerrer mit stetig oder stufig einstellbarer Laufzeitcharakteristik benötigt, die bei einer vorgegebenen Referenzfrequenz einen einstellungsunabhängigen Fixpunkt der Laufzeit aufweisen und deren Betriebsdämpfung im vorgesehenen Frequenzbereich nicht von den Einstellungen des Entzerrers abhängt und möglichst konstant ist.

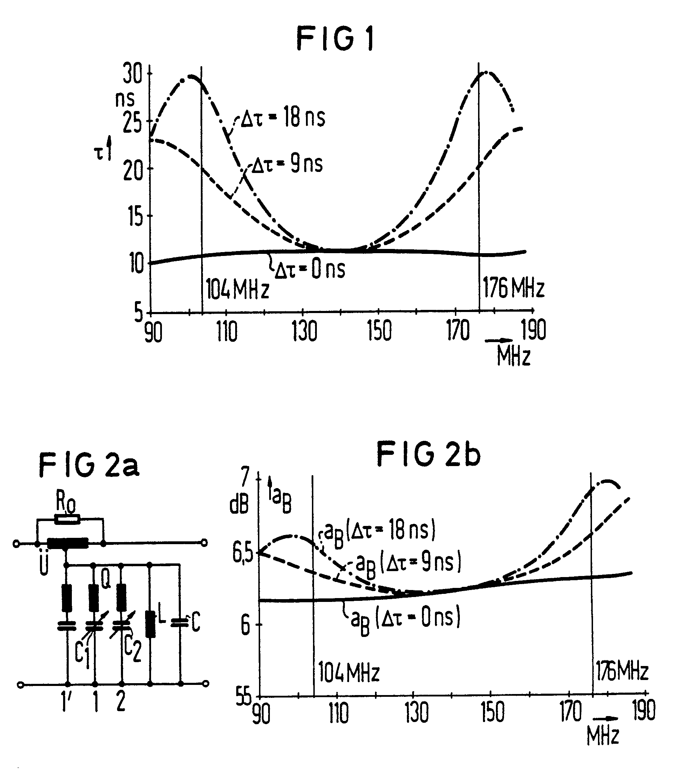

Während die bekannt gewordenen Realisierungsformen derartiger einstellbarer Laufzeitentzerrer (Frequenz 38 (1984), Heft, 2, S. 30 bis 60), z. B. in der vorteilhaften Darlington-Schaltung im verlustlosen Fall eine laufzeiteinstellungsunabhängige Betriebsdämpfung von $a_B = 6.02$ dB = const. gewährleisten, treten in der Praxis - verursacht durch die endlichen Güten der Bauelemente - frequenzabhängige Verläufe der Betriebsdämpfung auf, die in unerwünschter Weise von den Einstellungen des Laufzeitentzerrers abhängen, wie dies später in Fig. 2b am Beispiel eines einstellbaren Laufzeit-Parabel-Entzerrers (Frequenz 38 (1984), Heft 3, S. 54 - 62) gezeigt ist. Durch die spezielle Art der Bemessung des Laufzeitentzerrers ist jedoch gewährleistet, daß bei der vorgegebenen Referenzfrequenz auch ein einstellungsunabhängiger Fixpunkt der Betriebsdämpfung auftritt.

Diesem Stand der Technik entsprechend wird zum einstellbaren, verlustbehafteten Laufzeitentzerrer ein einstellbarer Dämpfungsentzerrer in Kette geschaltet, der so bemessen ist und synchron zu den Laufzeiteinstellungen so gesteuert wird, daß die Dämpfungssummenkurve der beiden Netzwerke bei allen Laufzeiteinstellungen im Rahmen der zulässigen Toleranzen den gleichen frequenzabhängigen Verlauf aufweist.

Dieser einstellbare Dämpfungsentzerrer verursacht wegen des erforderlichen Bauteile- und Abgleichaufwandes und wegen seines Platzbedarfes zusätzliche Kosten und bringt elektrische Nachteile in Form einer relativ hohen Grunddämpfung und einer frequenzabhängigen Laufzeit mit sich. Die Dimensionierung des einstellbaren Dämpfungsentzerrers wird durch den Zwang eingeschränkt, daß bei der Referenzfrequenz ein einstellungsunabhängiger Dämpfungswert auftreten muß.

Aufgabe der Erfindung ist es, einen dämpfungshubkompensierten, einstellbaren Laufzeitentzerrer anzugeben, bei dem unter anderem die den verschiedenen Laufzeiteinstellungen entsprechenden Dämpfungskurven jeweils in die niveaumäßig höchste Dämpfungskurve übergeführt werden können.

In vorteilhafter Weise bleibt bei der angegebenen Dämpfungsnachsteuerung im einstellbaren Laufzeitentzerrer der Fixpunkt der Dämpfung erhalten, es tritt keine zusätzliche Grunddämpfung auf, die ursprünglichen Laufzeitkurven erfahren im Rahmen der zulässigen Toleranzen keine Veränderung und der erforderliche Schaltungsaufwand ist minimal.

Erfindungsgemäß wird diese Aufgabe bei einem einstellbaren Laufzeitentzerrer nach dem Oberbegriff des Patentanspruches 1 gemäß den kennzeichnenden Merkmalen des Patentanspruches 1 gelöst.

Eine vorteilhafte Ausgestaltung ist im Anspruch 2 angegeben.

Anhand von Ausführungsbeispielen wird nachstehend die Erfindung noch näher erläutert. Es zeigen in der Zeichnung

Fig. 1    Laufzeitkurven $\tau$ in Nanosekunden eines einstellbaren Laufzeit-Parabel-Entzerrers mit Auslenkungen von $\Delta\tau = 0$ ns, $\Delta\tau = 9$ ns, $\alpha\tau = 18$ ns bei den Bereichs-Randfrequenzen f = 104 MHz und f = 176 MHz,

Fig. 2a    die Darlington-Schaltung eines Laufzeit-Parabel-Entzerrers, bei dem die Einstellbarkeit der Laufzeitkurven durch die Steuerung von zwei Kondensatoren erreicht wird,

Fig. 2b    den Laufzeitkurven in Fig. 1 entsprechende Dämpfungskurven $a_B$ des verlustbehafteten (Q) Laufzeit-Parabel-Entzerrers (Fig. 2a) ohne erfindungsgemäße Kompensation,

Fig. 3a    eine erfindungsgemäße Güteregulierung der laufzeitsteuernden Kondensatoren $C_1$ und $C_2$ mittels je eines veränderbaren ohmschen Widerstandes $R_1$ und $R_2$,

Fig. 3b    Dämpfungskurven $a_B$ der erfindungsgemäßen Schaltung (Fig. 3a) für die drei Laufzeitauslenkungen $\Delta\tau = 0$ ns, $\Delta\tau = 9$ ns, $\Delta\tau = 18$ ns (Fig. 1),

Fig. 4a    eine erfindungsgemäße Güteregulierung der laufzeitsteuernden Kondensatoren $C_1$ und $C_2$ mit nur einem veränderbaren ohmschen Widerstand R,

Fig. 4b    Dämpfungskurven $a_B$ der Schaltung nach Fig. 4a, für die Laufzeitauslenkungen $\Delta\tau = 0$ ns, $\Delta\tau = 9$ ns, $\Delta\tau = 18$ ns.

Im Ausführungsbeispiel von Fig. 2a ist eine Darlington-Schaltung verwendet, die aus einem Übertrager Ü besteht, dem ein überbrückender Widerstand $R_0$ zugeordnet ist. Am Anzapfungspunkt des im Längszweig liegenden Übertragers Ü liegen im Querzweig Reaktanzzweige, die mit 1', 1, 2, L und C bezeichnet sind. Im Ausführungsbeispiel bestehen diese Reaktanzzweige aus Serienresonanzkreisen mit einer Spule und einem Kondensator. Als einzelne weitere Reaktanzelemente sind die Spule L und der Kondensator C zu erkennen. Die Einstellbarkeit der Laufzeit erfolgt mit Hilfe der einstellbaren Kondensatoren $C_1$ und $C_2$ in den Reaktanzzweigen 1 und 2. Den Verlusten in den Reaktanzzweigen 1 und 2 wird mit dem Symbol Q die sogenannte Güte zugeordnet, durch deren Wirkung bekanntlich Störungen im Übertragungsverhalten des Laufzeitentzerrers auftreten.

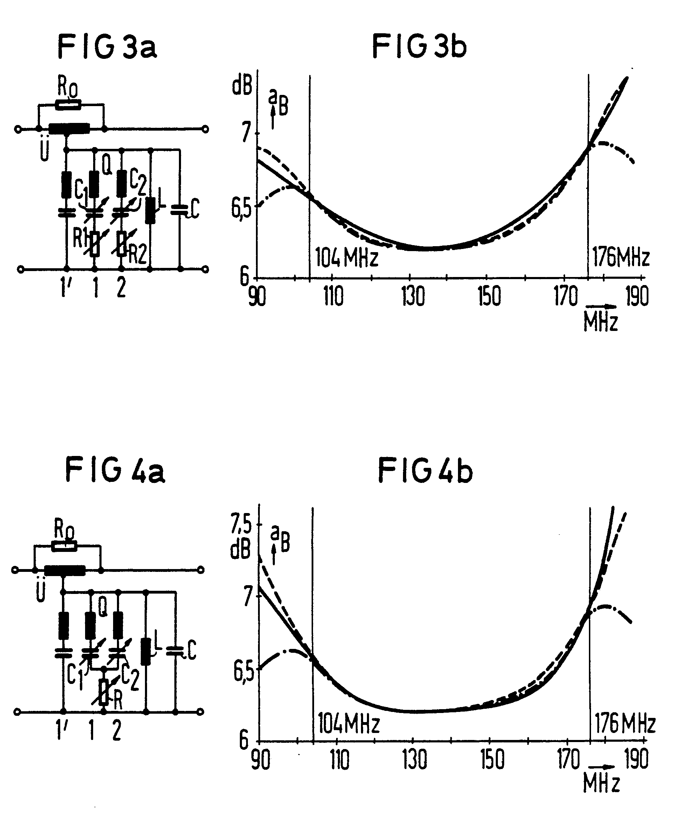

In der Schaltung von Fig. 3a erfolgt die Einstellung des Güte Q mit Hilfe der Widerstände $R_1$ und $R_2$, die je für sich in den Reaktanzzweigen 1 und 2 vorgesehen sind. Diese Widerstände sind im Beispiel in Serie zu den Resonanzkreisen geschaltet, sie können aber ebenso parallel zum Resonanzkreis oder auch parallel zu nur einem Schaltelement geschaltet sein.

In Fig. 4a sind die Reaktanzzweige 1 und 2 in Parallelschaltung zusammengefaßt und es ist dieser Parallelschaltung in Serie der einstellbare Widerstand R nachgeschaltet.

In den Fig. 3b und 4b ist die Betriebsdämpfung mit der hier beschriebenen Kompensation angegeben. Gegenüber der in Fig. 2b gezeichneten Betriebsdämpfung ohne Kompensation ist zu erkennen, daß in einem Frequenzbereich zwischen 104 und 176 MHz alle Betriebsdämpfungskurven den nahezu gleichen Verlauf aufweisen und somit unabhängig von den Einstellungen des Laufzeitentzerrers sind.

Zur weiteren Erläuterung sei noch folgendes ausgeführt.

Als Beispiel wird die Schaltung (Fig 2a) eines veränderbaren Laufzeit-Parabel-Entzerrers gemäß der eingangs bereits erwähnten Literaturstelle (Frequenz, Band 3, Heft 3, S. 54 - 62) angegeben, mit dem im Frequenzbereich f = 104...176 MHz die Erzeugung von quadratischen Laufzeitparabeln mit den Auslenkungen $\Delta\tau$ = 0...18 ns bei den Randfrequenzen erreichbar sind. In Fig. 1 sind die aus der verlustbehafteten Schaltung berechneten Laufzeitkurven für $\Delta\tau$ = 0 ns, $\Delta\tau$ = 9 ns und $\Delta\tau$ = 18 ns und in Fig. 2b die diesen Einstellungen zugeordneten Dämpfungskurven angegeben. Es ist zu erkennen, daß der Dämpfungshub bei der unteren Randfrequenz $\Delta a \approx 0.38$ dB und bei der oberen Randfrequenz $\Delta a \approx 0.57$ dB beträgt. Wird die Güte der laufzeitsteuernden Serienschwingkreise $L_1$, $C_1$ und $L_2$, $C_2$ mit stetig oder stufig veränderbaren Widerständen $R_1$ und und $R_2$ gesteuert (Fig. 3a), so gehen die niveaumäßig unteren Dämpfungskurven jeweils in die der Laufzeiteinstellung $\Delta\tau$ = 18 ns zugeordneten, niveaumäßig höchste Dämpfungskurve über (Fehler: etwa $\pm$ 0.04 dB), womit die Abhängigkeit der Dämpfungskurven von den Laufzeiteinstellungen weitgehend eliminiert ist. Die allen Laufzeiteinstellungen gemeinsame, niveaumäßige oberste Dämpfungskurve kann in konventioneller Weise durch Nachschalten eines fest abgestimmten Dämpfungsentzerrers zu einer frequenzkonstanten Dämpfung ergänzt werden.

In der in Fig. 4a dargestellten Schaltung werden die beiden laufzeitsteuernden Serienschwingkreise gemeinsam mit nur einem veränderbaren ohmschen Widerstand in der Güte so nachgeregelt, daß wiederum die den verschiedenen Laufzeiteinstellungen zugeordneten Dämpfungskurven auf die niveauhöchste Dämpfungskurve aufgefüllt werden.

**Patentansprüche**

1. Einstellbarer, mindestens einen Laufzeit-Fixpunkt aufweisender, verlustbehafteter Laufzeitentzerrer der insbesondere als Darlingtonschaltung aus einem Übertrager (Ü), einem Widerstand (Ro) und aus laufzeitbestimmenden Reaktanzzweigen (1', 1, 2, L, C) besteht, dadurch gekennzeichnet, daß die Güten (Q) der die laufzeitsteuernden Elemente enthaltenden Reaktanzzweige (1, 2) bzw. die Güten (Q) der laufzeitsteuernden Elemente selbst in Abhängigkeit von der Laufzeiteinstellung veränderbar ausgebildet sind, derart, daß die Gütesteuerung durch veränderbare ohmsche Widerstände ($R_1$, $R_2$, R) erfolgt, die in Serie oder parallel zu den die laufzeitsteuernden Elemente enthaltenden Reaktanzzweigen (1, 2) oder Teilen davon, bzw. in Serie oder parallel zu den laufzeitsteuernden Elementen selbst geschaltet sind.

2. Laufzeitentzerrer nach Anspruch 1, dadurch gekennzeichnet, daß die Güten von im Kapazitätswerte veränderbaren Kondensatoren ($C_1$, $C_2$) durch in Serie oder parallel geschaltete Widerstände ein stellbar sind.

3. Laufzeitentzerrer nach Anspruch 1 oder 2, dadurch gekennzeichnet, daß mehreren laufzeitsteuernden Elementen (1, 2) nur ein gemeinsamer veränderbarer ohmscher Widerstand (R) zugeordnet ist.

**Claims**

1. Lossy and adjustable delay equalizer having at least one fixed delay point, which consists, in particular as a Darlington circuit, of a transformer (Ü), a resistor (Ro) and of delay-determining reactance branches (1', 1, 2, L, C), characterized in that the quality factors (Q) of the reactance branches (1, 2) containing the delay-controlling elements and the quality factors (Q) of the delay-controlling elements themselves are constructed to be variable in dependence on the delay setting, in such a manner that the quality is controlled via variable ohmic resistances ($R_1$, $R_2$, R) which are connected in series with or parallel to the reactance branches (1, 2) or parts thereof, which contain the delay-controlling elements, or in series with or parallel to the delay-controlling elements themselves.

2. Delay equalizer according to Claim 1, characterized in that the quality factors of

capacitors ($C_1$, $C_2$), the capacitance values of which can be varied, can be adjusted by series-connected or parallel-connected resistances.

3. Delay equalizer according to Claim 1 or 2, characterized in that only one common variable ohmic resistance (A) is allocated to several delay-controlling elements (1, 2).

**Revendications**

1. Correcteur réglable de temps de propagation possédant au moins un point fixe du temps de propagation et présentant des pertes et constitué notamment sous la forme d'un montage de Darlington comprenant un transformateur (Ü), une résistance (Ro) et des branches de réactance (1', 1, 2, L, C) déterminant le temps de propagation, caractérisé par le fait que les facteurs de qualité (Q) des branches de réactance (1, 2) contenant les éléments commandant le temps de propagation, ou les facteurs de qualité (Q) des éléments commandant le temps de propagation eux-mêmes sont réglés de manière à être modifiables en fonction du réglage du temps de propagation, de telle sorte que la commande des facteurs de qualité s'effectue à l'aide de résistances ohmiques variables ($R_1$, $R_2$, R), qui sont branchées en série ou en parallèle avec les branches de réactance (1, 2) contenant les éléments commandant le temps de propagation, ou avec des parties de ces branches, ou bien en série ou en parallèle avec les éléments commandant le temps de propagation, eux-mêmes.

2. Correcteur de temps de propagation suivant la revendication 1, caractérisé par le fait que les facteurs de qualité de condensateurs ($C_1$, $C_2$), dont les capacités sont variables, peuvent être réglés au moyen de résistances branchées en série ou en parallèle.

3. Correcteur du temps de propagation suivant la revendication 1 ou 2, caractérisé par le fait qu'une seule résistance ohmique variable commune (R) est associée à plusieurs éléments (1, 2) commandant le temps de propagation.

# FIG 1

# FIG 2a

# FIG 2b

# FIG 3a

# FIG 3b

# FIG 4a

# FIG 4b

3